**Europäisches Patentamt**

**European Patent Office**

**Office européen des brevets**

(19)

(11) Veröffentlichungsnummer : **0 473 538 A1**

(12) # EUROPÄISCHE PATENTANMELDUNG

(21) Anmeldenummer : **91710028.1**

(22) Anmeldetag : **24.08.91**

(51) Int. Cl.⁵ : **C11D 7/50, C23G 5/032**

(30) Priorität : **30.08.90 DE 4027446**

(43) Veröffentlichungstag der Anmeldung :
**04.03.92 Patentblatt 92/10**

(84) Benannte Vertragsstaaten :
**AT BE CH DE DK ES FR GB GR IT LI NL SE**

(71) Anmelder : **Kali-Chemie Aktiengesellschaft**
**Postfach 220, Hans-Böckler-Allee 20**
**W-3000 Hannover 1 (DE)**

(72) Erfinder : **Buchwald, Hans**
**Am Rodelberg 51A**
**W-3003 Ronnenberg 3 (DE)**
Erfinder : **Brackmann, Andreas**
**Hedwigstrasse 10**
**W-3000 Hannover 1 (DE)**
Erfinder : **Raszkowski, Boleslaus**
**In der Hespe 246**
**W-3061 Wiedensahl (DE)**

(74) Vertreter : **Lauer, Dieter, Dr.**
**c/o Solvay Deutschland GmbH, Postfach 220**
**W-3000 Hannover (DE)**

(54) **Fluorchlorkohlenwasserstoff-freie Reinigungszusammensetzungen.**

(57)    Beschrieben werden neue Fluorchlorkohlenwasserstoff-freie Reinigungszusammensetzungen auf Basis von Alkoholen bzw. partiell fluorierten Alkoholen mit 2 bis 4 C-Atomen, die ausgewählte oberflächenaktive Agentien enthalten.

EP 0 473 538 A1

Die Erfindung bezieht sich auf Fluorchlorkohlenwasserstoff-freie Reinigungszusammensetzungen auf Basis von Alkoholen.

An Lösungsmittel für die Reinigung von elektronischen Bauteilen, gedruckten Leiterplatten, empfindlichen Geräteteilen, Präzisionsgeräten und Schutzschaltungen, wie z.B. Fehlerstromschutzschaltern, werden hohe Anforderungen betreffend die Löseeigenschaften im Hinblick auf die zu entfernenden Verunreinigungen gestellt. Da diese Anforderungen sich in der Regel nicht mit nur einem einzigen reinen Lösungsmittel erfüllen lassen, werden im Stand der Technik für industrielle Reinigungsverfahren häufig Lösungsmittelgemische eingesetzt. Viele solcher Lösungsmittelgemische des Standes der Technik enthalten Fluorchlorkohlenwasserstoffe wegen deren bekannt guten Löseeigenschaften als Hauptlösungsmittel. Die Fluorchlorkohlenwasserstoffe sind jedoch mit dem großen Nachteil behaftet, daß sie in den oberen Luftschichten der Erdatmosphäre zur gefährlichen Verminderung des Ozongehaltes beitragen. Aufgrund dieser umweltbeeinträchtigenden Eigenschaft der Fluorchlorkohlenwasserstoffe ist ein Ersatz von Reinigungszusammensetzungen, die diese Fluorchlorkohlenwasserstoffe enthalten, durch alternative Reinigungszusammensetzungen mit in dieser Hinsicht weniger bedenklichen Lösungsmitteln wünschenswert. Es ist im Stand der Technik weiterhin zwar bereits bekannt, den Fluorchlorkohlenwasserstoffen Alkohole als Colösungsmittel zuzusetzen; die alleinige Verwendung von Alkoholen als Hauptlösungsmittel führte in schwierigen Anwendungsfällen nicht zum Erfolg.

Es wurde nun gefunden, daß Reinigungszusammensetzungen, die aus 99,5 bis 80,0 Gew.-% eines einwertigen, gegebenenfalls teilweise fluorierten C2- bis C4-Alkohols, 0,5 bis 10 Gew.-% eines oberflächenaktiven Agens, welches ausgewählt ist aus Ammoniumsalzen von Alkylbenzolsulfonaten und/oder Gemischen von Fettsäurealkanolamiden und Alkylphenolpolyglykolethern, und gegebenenfalls aus bis zu 10,0 Gew.-% entionisiertem Wasser bestehen, wobei die Summe der Bestandteile 100 Gew.-% ist, gut für industrielle Reinigungsverfahren geeignet sind, obwohl sie kein Fluorchlorkohlenwasserstoff-Lösungsmittel enthalten. In einer Ausgestaltung der Erfindung zeichnen sich die erfindungsgemäßen wasserhaltigen Reinigungszusammensetzungen dadurch aus, daß sie 1,0 bis 10,0 Gew.-% Wasser enthalten. In einer weiteren Ausgestaltung der erfindungsgemäßen Reinigungszusammensetzungen zeichnen sich diese dadurch aus, daß sie 0,5 bis 5,0 Gew.-% des oberflächenaktiven Agens enthalten.

In einer Variante der Erfindung enthalten die Reinigungszusammensetzungen als oberflächenatkives Agens ein Gemisch aus Fettsäurealkanolamid und Alkylphenolpolyglykolethern. Geeignete Fettsäurealkanolamide sind z.B. N-alkylierte Fettsäureamide der allgemeinen Formel $R^1$-CO-N($R^2$)-$(CH_2)_n$-OH, die durch Umsetzung von Alkanolaminen mit Fettsäuren, Fettsäuremethylestern oder Fettsäureglyceriden erhältlich sind, wobei $R^1$ für einen gesättigten oder ungesättigten Fettsäurerest, $R^2$ für Wasserstoff in Monoalkanolamiden oder für -$(CH_2)_n$-OH in Fettsäuredialkanolamiden steht und n eine ganze Zahl von 1 bis 6, bevorzugt aber die Zahl 2, bedeutet. Bevorzugt sind insbesondere Fettsäuredialkanolamide, besonders Fettsäurediethanolamide, worin der Rest $R^1$ der Fettsäurerest der Laurinsäure, Myristinsäure, Palmitinsäure, Stearinsäure, der Ölsäure und ggf. auch ein Fettsäurerest der Kokosfettsäuren ist. Geeignete Alkylphenolpolyglykolether sind z.B. solche mit mittleren Alkylresten, d.h. mit den C8- bis C12-Alkylresten Octyl, Nonyl, Decyl, Undecyl oder Dodecyl, und mit 5 bis 8 Ethylenoxideinheiten. In einer bevorzugten Ausgestaltung dieser Variante der Erfindung ist in den Reinigungszusammensetzungen ein Gemisch aus Ölsäurediethanolamid und Nonylphenolpolyglykolether mit 7 bis 8 Ethylenoxideinheiten enthalten. Besonders bevorzugt sind hierbei Reinigungszusammensetzungen, in denen das Ölsäurediethanolamid zu den Nonylphenolpolyglykolethern im Gewichtsverhältnis 5:1 vorliegt.

In einer anderen Variante der erfindungsgemäßen Reinigungszusammensetzungen ist das oberflächenaktive Agens ein Ammoniumsalz eines Alkylbenzolsulfonates. Geeignete Alkylbenzolsulfonate sind z.B. solche mit mittleren Alkylresten, d.h. mit den C8- bis C12-Alkyresten Octyl, Nonyl, Decyl, Undecyl oder Dodecyl. Es können in den erfindungsgemäßen Reinigungszusammensetzungen Ammoniumsalze der Alkylbenzolsulfonate mit z.B. den folgenden Aminen mit 2 bis 6 C-Atomen enthalten sein: Diethylamin, n-Propylamin, Isopropylamin, Diisopropylamin, n-Butylamin, Isobutylamin, tert-Butylamin, Cyclohexylamin. In einer bevorzugten Ausgestaltung dieser Variante der Erfindung zeichnen sich die Reinigungszusammensetzungen dadurch aus, daß sie als Alkybenzolsulfonat-Ammoniumsalz das Isopropylammoniumdodecylbenzolsulfonat enthalten.

Die in den erfindungsgemäßen Reinigungszusammensetzungen enthaltenen Alkohole können in einer Variante der erfindungsgemäßen Reinigungszusammensetzungen Ethanol, Propanol, Isopropanol oder Butanol sein. Bevorzugte Alkohole dieser Variante der Erfindung sind Ethanol und insbesondere Isopropanol.

In einer anderen Variante der erfindungsgemäßen Reinigungszusammensetzungen ist der Alkohol ein teilweise fluorierter Alkohol

Teilweise fluorierte Alkohole im Sinne der Erfindung sind Alkohole, die außer der OH-Gruppe und den zwei bis vier Kohlenstoffatomen, Wasserstoff und wenigstens ein Fluoratom enthalten. Die in den erfindungsgemäßen Zusammensetzungen enthaltenen, teilweise fluorierten-Alkohole mit 2 bis 4 C-Atomen sind z.B. ausgewählt aus der Gruppe 2-Fluorethanol, 1,1-Difluorethanol-(2), 2,2,2-Trifluorethanol, 2-Fluorpropanol, 3-Fluorpropanol, 3,3-Difluorpropanol, 2,2-Difluorpropanol, 1,1-Difluorpropanol-(2), 3,3,3-Trifluorpropanol, 2,3,3,3-Tetrafluorpropanol, 2,2,3,3-Tetrafluorpropanol, 2,2,3,3,3-Pentafluorpropanol, 4-Fluorbutanol und 4,4,4-Trifluorbutanol. Besonders bevorzugt sind 2,2,2-Trifluorethanol (im folgenden kurz als Trifluorethanol bezeichnet), 2,2,3,3-Tetrafluorpropanol und insbesondere aber 2,2,3,3,3-Pentafluorpropanol.

Die oben genannten Reinigungszusammensetzungen haben zahlreiche Anwendungsmöglichkeiten auf dem Sektor der Reinigung. Bei diesen an sich bekannten Verfahren wird der zu reinigende Gegenstand in einer oder mehreren Stufen in eine flüssige Reinigungszusammensetzung getaucht oder mit einer flüssigen Reinigungszusammensetzung besprüht. Die Reinigungswirkung kann bei weniger empfindlichen, zu reinigenden Gegenständen auch durch geeignete Maßnahmen, wie z.B. Ultraschall und/oder Rühren, sowie durch mechanische Einwirkung, wie z.B. Bürsten, gesteigert werden.

Die erfindungsgemäßen Reinigungszusammensetzungen eignen sich insbesondere zur Reinigung von elektronischen Bauteilen, gedruckten Leiterplatten, empfindlichen Geräteteilen, Präzisionsgeräten und Schutzschaltungen, wie z.B. Fehlerstromschutzschaltern. Die hohen Anforderungen an die Reinigung dieser Gegenstände werden durch die erfindungsgemäßen Reinigungszusammensetzungen gut erfüllt. Besonders gut eignen sich die erfindungsgemäßen Reinigungszusammensetzungen zur Entfernung von organischen Harzflußmitteln, wie sie die elektronische Industrie für Lötverfahren verwendet und deren Überschüsse nach dem Lötvorgang von Leiterplatten entfernt werden müssen. Die zu entfernenden Harzflußmittel sind Gemische polarer und nicht polarer Verbindungen und enthalten oftmals zusätzliche spezielle Aktivatoren, die zwar einerseits den Lötvorgang unterstützen, anderersei-its aber die Entfernung des Harzlötflußmittels von den zu reinigenden Oberflächen erschweren. Solche Aktivatoren sind z.B. organische halogenhaltige Aktivatoren, wie z.B. Glutaminsäurehydrochlorid, oder es sind organische halogenfreie Aktivierungszusätze, wie z.B. Stearin-, Salicyl- oder Adipinsäure. Überraschenderweise können mit den erfindungsgemäßen Reinigungszusammensetzungen diese Harzflußmittel, insbesondere auch solche mit hohem Aktivatorgehalt, gut entfernt werden. So lassen sich unbestückte und bestückte (insbesondere auch SMD-bestückte) Leiterplatten auch bei Verwendung von Flußmitteln mit hohem Aktivatoranteil wirksamen reinigen.

Die erfindungsgemäßen Reinigungszusammensetzungen können beispielsweise auch zur Reinigung von Kleinteilen bzw. Schüttgut, sowie zur Entfernung von Fett- und Fingerabdrücken bzw. polaren Substanzen von elektronischen Bauteilen, z.B. von Silicium-Wafern, eingesetzt werden.

Die mit den erfindungsgemäßen Reinigungszusammensetzungen erzielbare Reinigungswirkung überrascht, da die Oberflächenspannungen der Reinigungszusammensetzungen trotz der darin enthaltenen oberflächenaktiven Agentien gegenüber den Werten für die reinen Alkohole kaum vermindert sind bzw. insbesondere bei den wasserenthaltenden Zusammensetzungen sogar über den Werten der reinen Alkohole liegen.

Die nachfolgenden Beispiele sollen die Erfindung weiter erläutern, ohne sie jedoch in ihrem Umfang zu begrenzen. Sofern nicht anders angegeben, sind % immer Gew.-%.

Beispiel 1: Reinigung von Leiterplatten

In einer handelsüblichen Mehrkammer-Reinigungsanlage wurden Reinigungsversuche mit Leiterplatten, die sowohl mit üblichen halogenhaltigen Lötflußmitteln als auch mit stark aktivatorhaltigen Lötflußmitteln verununreinigt waren, vorgenommen. Die zu reinigenden Leiterplatten waren mit folgenden Harzflußmitteln verunreinigt:

A: Harzflußmittel auf Basis natürlicher oder modifizierter natürlicher Harze mit organischen halogenfreien Aktivierungszusätzen (z.B. Stearin-, Salicyl- oder Adipinsäure), jedoch ohne Amine, Diamine oder Harnstoff; verwendet wurden zwei handelsübliche Flußmittel der Type F-SW-32 (A 1 und A 2).

B: Harzflußmittel auf Basis natürlicher Harze oder modifizierter natürlicher Harze mit Zusätzen organischer halogenhaltiger Activatoren (z.B. Glutaminsäurehydrochlorid); verwendet wurde ein handelsübliches Flußmittel der Type F-SW-26 (B).

Zur Reinigung, d.h. zur Entfernung der Harzflußmittel, wurden die zu reinigenden Leiterplatten drei Minuten unter Ultraschall in ein erstes Reinigungsbad (Zusammensetzung siehe Tabelle 1), danach eine Minute unter Ultraschall in ein zweites Reinigungsbad getaucht und anschließend noch eine Minute im Dampfraum gespült (im zweiten Reinigungsbad und im Dampfraum wurde der jeweilige reine Alkohol verwendet). Sowohl die Verunreinigungen durch die üblichen halogenhaltigen als auch durch stark aktivatorhaltige Lötflußmittel konnten von den Leiterplatten wirksam entfernt werden. Die bei den Versuchen mit den erfindungsgemäßen Reinigungszusammensetzungen erhaltenen Ergebnisse sind in Tabelle 1 wiedergegeben.

## Tabelle 1  Erfindungsgemäße Zusammensetzungen

| Nr. | Zusammensetzung * in Bad 1 | Harzfluß- mittel | Reinigungsergebnis |
|---|---|---|---|
| 1 | 95 % Ethanol<br>5 % ODA/NPE | A1 | ++ |
| 2 | 95 % Ethanol<br>5 % IDS | A1 | ++ |
| 3 | "          " | A2 | + |
| 4 | 95 % Isopropanol<br>5 % ODA/NPE | A1 | ++ |
| 5 | 95 % Isopropanol<br>5 % IDS | A1 | ++ |
| 6 | "          " | A2 | ++ |
| 7 | "          " | B | ++ |
| 8 | 95 % Pentafluor-<br>propanol<br>5 % ODA/NPE | A1 | + |
| 9 | "          " | A2 | + |
| 10 | "          " | B | + |
| 11 | 95 % Pentafluor-<br>propanol<br>5 % IDS | A1 | + |
| 12 | "          " | A2 | ++ |
| 13 | "          " | B | ++ |

* ODA/NPE  = Ölsäurediethanolamid/Nonylphenol-
              polyglykolether (5:1)

  IDS       = Isopropylammoniumdodecylbenzolsulfonat

In den in der Spalte "Reinigungsergebnis" mit "++" gekennzeichneten Fällen ist eine sehr gute und in den mit "+" gekennzeichneten Fällen eine gute Reinigungswirkung erzielt worden und es kam nicht zur Bildung "weißer Beläge" auf den zu reinigenden Leiterplatten. Es ist deutlich sichtbar, daß die erfindungsgemäßen Reinigungszusammensetzungen wirksame Reinigungsleistungen zeigen.

Vergleichsbeispiel:

Zu Vergleichszwecken wurden analog zum Beispiel 1 einige mit den schwieriger zu entfernenden Harzflußmitteln (A2, B) verunreinigte Leiterplatten mit reinen Alkoholen gereinigt. Die Reinigungsergebnisse sind

4

in Tabelle 2 zusammengestellt.

```
Tabelle 2   Vergleichsversuche


   Nr. |    Zusammensetzung    |  Harzfluß- |  Reinigungsergebnis
       |                       |  mittel    |
  -----|-----------------------|------------|--------------------------
       |                       |            |
   V 1 |    Ethanol            |     A2     |  deutliche Rückstände
       |                       |            |
   V 2 |    Isopropanol        |     A2     |  leichte Rückstände
       |                       |            |
   V 3 |    "       "          |     B      |  starke Rückstände
       |                       |            |
   V 4 |    Pentafluorpropanol |     A2     |  leichte Rückstände
       |                       |            |
   V 5 |    "       "          |     B      |  weiße Beläge
```

Die Reinigungsversuche des Beispiels 1 (Tabelle 1, Nr. 1 bis 13) und des Vergleichsbeispiels (Tabelle 2, V 1 bis V 5) zeigen, daß reine Alkohole zur Flußmittelentfernung nur sehr bedingt einsetzbar sind, die erfindungsgemäßen Zusammensetzungen dagegen einen wirksamen Reinigungserfolg gewährleisten. Dieses überrascht umsomehr, da die erfindungsgemäßen Zusammensetzungen des Beispiels 1 im Vergleich zum reinen Alkohol nur eine kaum verringerte Oberflächenspannung zeigen. Die Reinigungswirkung von Zusammensetzungen auf Basis von Isopropanol ist hierbei höher als die Reinigungswirkung von Zusammensetzungen auf Basis von Ethanol. Ein besonders guter Reinigungserfolg wird hierbei mit Zusammensetzungen erzielt, die als oberflächenaktives Agens Isopropylammoniumdodecylbenzolsulfonat enthalten.

Wie die Versuche des Beispiels 1 und des Vergleichsbeispiels weiterhin zeigen, wird bei Verwendung von reinem Pentafluorpropanol zur Flußmittelentfernung allenfalls ein befriedigendes Reinigungsergebnis erzielt; demgegenüber gewährleisten die erfindungsgemäßen Zusammensetzungen auf Basis Pentafluorpropanol, die eines der genannten oberflächenaktiven Agentien, insbesondere aber das Isopropylammoniumdodecylbenzolsulfonat enthalten, einwandfreie Reinigungserfolge.

Beispiel 2: Reinigung von Siliciumscheiben

Siliciumscheiben (Silicium-Wafer) wurden zur Entfernung von Fingerabdrücken analog zum Beispiel 1 (3 Minuten Ultraschall, 1 Minute Ultraschall, 1 Minute Dampfentfettung) mit einer Zusammensetzung in Bad 1 aus 95 Gew.-% Ethanol und 5 % Gew.-% eines Gemisches aus Ölsäurediethanolamid/Nonylphenolpolyglykolether (5:1) gereinigt. Nach der Behandlung war das Reinigungsgut einwandfrei sauber.

**Patentansprüche**

1. Fluorchlorlohlenwasserstoff-freie Reinigungszusammensetzungen auf Basis von Alloholen, bestehend aus 99,5 bis 80,0 Gew.,-% eines einwertigen, ggf. teilweise fluorierten C2- bis C4-Alkohols, 0,5 bis 10 Gew.-% eines oberflächenaltiven Agens, welches ausgewählt ist aus Ammoniumsalzen von Alkylbenzolsulfonaten und/oder Gemischen von Fettsäurealkanolamiden und Alkylphenolpolyglylolethern, und ggf. bis zu 10,0 Gew.-% entioniersiertem Wasser, wobei die Summe der Bestandteile 100 Gew.-% ist.

2. Reinigungszusammensetzungen nach Anspruch 1, dadurch gekennzeichnet, daß sie 1,0 bis 10,0 Gew.-% Wasser enthalten.

3. Reinigungszusammensetzungen nach Anspruch 1, dadurch gekennzeichnet, daß sie 0,5 bis 5,0 Gew.-% des oberflächenaltiven Agens enthalten.

4. Reinigungszusammensetzungen nach Anspruch 1, dadurch gekennzeichnet, daß sie als Fettsäurealkanolamid/Alkylphenolpolyglykolether-Gemisch ein Gemisch aus Ölsäurediethanolamid und Nonylphenolpolyglykolethern mit 7 bis 8 Ethylenoxideinheiten enthalten.

5. Reinigungszusammensetzungen nach Anspruch 4, dadurch gelennzeichnet, daß das Ölsäurediethanolamid zu den Nonylphenolpolyglykolethern im Gewichtsverhältnis 5:1 vorliegt.

6. Reinigungszusammensetzungen nach Anspruch 1, dadurch gekennzeichnet, daß sie als Alkylbenzolsulfonat-Ammoniumsalz das Isopropylammoniumdodecylbenzolsulfonat enthalten.

7. Reinigungszusammensetzungen nach Anspruch 1, dadurch gekennzeichnet, daß sie als Alkohol Ethanol oder Isopropanol enthalten.

8. Reinigungszusammensetzungen nach Anspruch 1, dadurch gekennzeichnet, daß sie als Alkohol einen teilweise fluorierten Alkohol, vorzugsweise Pentafluorpropanol, enthalten.

9. Verfahren zum Reinigen von Oberflächen, dadurch gekennzeichnet, daß man die Oberflächen mit einer Reinigungszusammensetzung nach einem der Ansprüche 1 bis 8 behandelt.

10. Verfahren nach Anspruch 9, dadurch gekennzeichnet, daß die zu reinigenden Oberflächen mit Lötflußmitteln, Lötflußmittelrückständen, mit Fingerabdrücken und/oder polaren Substanzen verunreinigte Oberflächen sind.

EP 0 473 538 A1

Europäisches Patentamt

**EUROPÄISCHER RECHERCHENBERICHT**

Nummer der Anmeldung

## EINSCHLÄGIGE DOKUMENTE

EP 91710028.1

| Kategorie | Kennzeichnung des Dokuments mit Angabe, soweit erforderlich, der maßgeblichen Teile | Betrifft Anspruch | KLASSIFIKATION DER ANMELDUNG (Int Cl.⁵) |
|---|---|---|---|
| P,X | <u>EP - A - 0 394 994</u><br>(DAIKINUINDUSTRIES)<br>  * Page 3, lines 6-41; page 6, lines 8-16; example 19; claims 1-3,8-14 *<br>---- | 1-3, 8-10 | C 11 D 7/50<br>C 23 G 5/032 |

| | RECHERCHIERTE SACHGEBIETE (Int. Cl.⁵) |
|---|---|
| | C 11 D<br>C 23 G<br>H 05 K |

Der vorliegende Recherchenbericht wurde für alle Patentansprüche erstellt.

| Recherchenort | Abschlußdatum der Recherche | Prüfer |
|---|---|---|
| WIEN | 18-11-1991 | SEIRAFI |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

7